# EUROPEAN PATENT SPECIFICATION

(11) **EP 4 306 299 B1**
(45) Date of publication and mention of the grant of the patent: **25.06.2025**
(21) Application number: 21930212.2
(22) Date of filing: 12.03.2021
(51) Int. Cl.: B29C 64/245, B29C 64/393, B33Y 10/00, B33Y 30/00, B33Y 50/02, B29C 37/00, G01N 21/84

(54) **DETERMINATION DEVICE**
BESTIMMUNGSVORRICHTUNG
DISPOSITIF DE DÉTERMINATION

(43) Date of publication of application: 17.01.2024
(73) Proprietor: Fuji Corporation, Chiryu-shi, Aichi 472-8686 (JP)
(72) Inventor: TAKAYANAGI, Masakazu, Chiryu-shi, Aichi 472-8686 (JP)
(74) Representative: Grünecker Patent- und Rechtsanwälte PartG mbB
(86) International application number: PCT/JP2021/010080
(87) International publication number: WO 2022/190360

(56) References cited:
- WO-A1-2014/185100
- CN-A- 104 011 593
- JP-A- 2004 162 095
- JP-A- 2012 506 803
- JP-A- 2019 142 096
- US-B2- 7 913 734

## Description

### Technical Field

The present invention relates to a determination device used in a shaping device in which a three-dimensional shaped object is shaped on an upper surface of a film adhered to a pallet, for the determination device determining whether the film is adhered to the pallet.

### Background Art

In the following Patent Literature, a technique for shaping a three-dimensional shaped object on a pallet is described.

### Patent Literature

Patent Literature 1: JP-A-2004-162095

WO2014/185100 A1 discloses a determination device for a shaping device to determine the position of a portion of a film.

### Summary of the Invention

### Technical Problem

In order to prevent damage to the three-dimensional shaped object when the shaped three-dimensional shaped object is removed from the pallet, the film may be adhered to the pallet, and the three-dimensional shaped object may be shaped on the upper surface of the film. In such a case, it is necessary to determine whether the film is adhered to the pallet, and it is an object of the present description to appropriately determine whether the film is adhered to the pallet.

### Solution to Problem

In order to solve the above problem, the present description discloses a determination device used in a shaping device in which a three-dimensional shaped object is shaped on an upper surface of a film adhered to a pallet, the determination device determining whether the film is adhered to the pallet based on imaging data of the pallet.

### Advantageous Effect of the Invention

According to the present disclosure, it is possible to appropriately determine whether a film is adhered to a pallet based on imaging data of the pallet.

### Brief Description of Drawings

Fig. 1 is a diagram illustrating a circuit formation device.
Fig. 2 is a block diagram illustrating a control device.
Fig. 3 is a cross-sectional view illustrating a heat-sensitive release film adhered to a pallet.
Fig. 4 is a cross-sectional view illustrating a circuit board in a state in which a resin laminate is formed.
Fig. 5 is a cross-sectional view illustrating a circuit board in a state in which wiring is formed on the resin laminate.
Fig. 6 is a plan view illustrating a pallet in a state in which the heat-sensitive release film is not adhered when whether the heat-sensitive release film is adhered is determined using a mark.
Fig. 7 is a plan view illustrating a pallet in a state in which the heat-sensitive release film is adhered when whether the heat-sensitive release film is adhered is determined using a mark.
Fig. 8 is a plan view illustrating a pallet in a state in which the heat-sensitive release film is not adhered when whether the heat-sensitive release film is adhered is determined using a brightness value.
Fig. 9 is a plan view illustrating a pallet in a state in which the heat-sensitive release film is adhered when whether the heat-sensitive release film is adhered is determined using a brightness value.
Fig. 10 is a plan view illustrating a pallet in a state in which the heat-sensitive release film is not adhered when whether the heat-sensitive release film is adhered is determined using a boundary line between the heat-sensitive release film and the pallet.
Fig. 11 is a plan view illustrating a pallet in a state in which the heat-sensitive release film is adhered when whether the heat-sensitive release film is adhered is determined using a boundary line between the heat-sensitive release film and the pallet.
Fig. 12 is a plan view illustrating a pallet when an adhesion position of the heat-sensitive release film is calculated based on the boundary line between the heat-sensitive release film and the pallet.

### Description of Embodiments

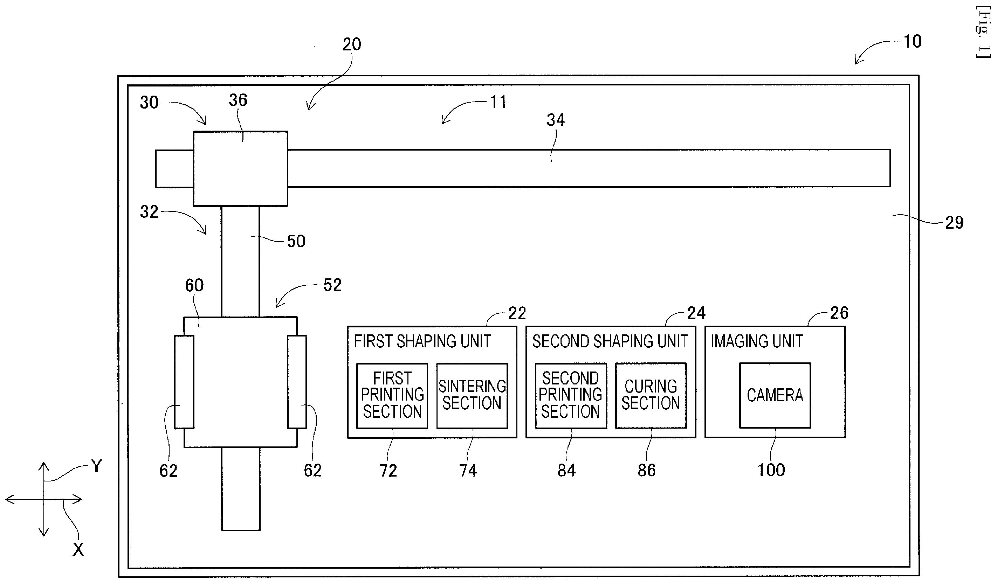

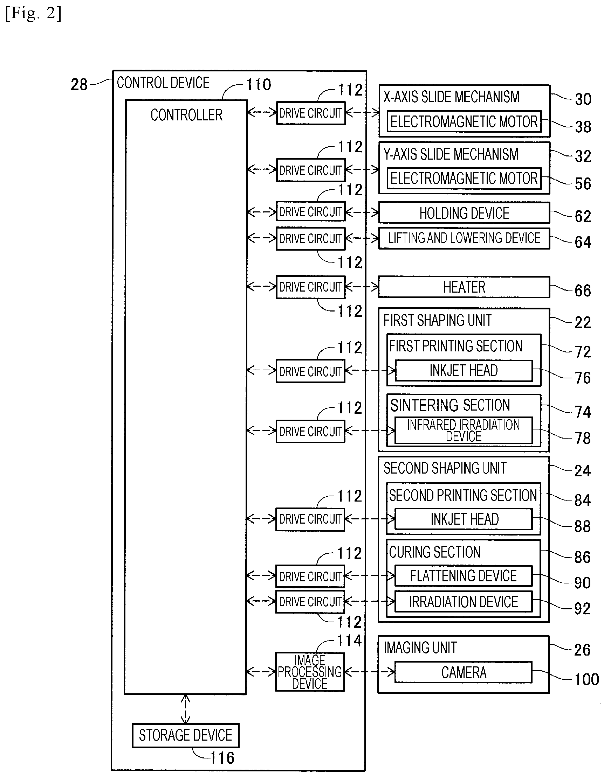

Fig. 1 illustrates circuit formation device 10. Circuit formation device 10 includes conveyance device 20, first shaping unit 22, second shaping unit 24, imaging unit 26, and control device 28 (refer to Fig. 2). Conveyance device 20, first shaping unit 22, second shaping unit 24, and imaging unit 26 are disposed on base 29 of circuit formation device 10. Base 29 has a generally rectangular shape, and in the following description, a longitudinal direction of base 29 will be referred to as an X-axis direction, a shorter direction of base 29 will be referred to as a Y-axis direction, and a direction orthogonal to both the X-axis direction and the Y-axis direction will be referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. X-axis slide mechanism 30 further includes electromagnetic motor 38 (refer to Fig. 2), and X-axis slider 36 is moved to any position in the X-axis direction by driving electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end portion of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor 56 (refer to Fig. 2), and stage 52 is moved to any position in the Y-axis direction by driving electromagnetic motor 56. In this manner, stage 52 is moved to any position on base 29 by driving X-axis slide mechanism 30 and Y-axis slide mechanism 32.

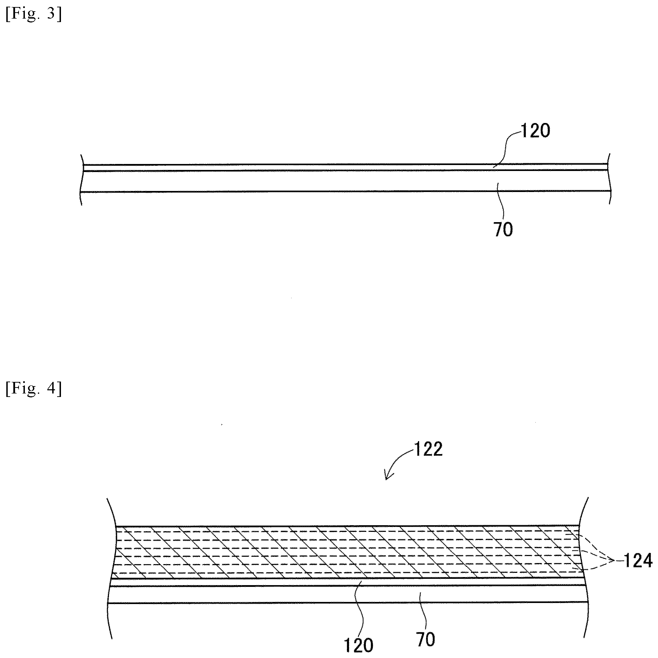

Stage 52 includes base plate 60, holding device 62, lifting and lowering device 64 (refer to Fig. 2), and heater 66 (refer to Fig. 2). Base plate 60 is formed in a flat plate shape, and pallet 70 (refer to Fig. 3) is placed on an upper surface thereof. Holding devices 62 are provided on both side portions of base plate 60 in the X-axis direction. Then, both edge portions of pallet 70 placed on base plate 60 in the X-axis direction are sandwiched by holding devices 62, so that pallet 70 is fixedly held. In addition, lifting and lowering device 64 is disposed below base plate 60, and lifts and lowers base plate 60. Heater 66 is incorporated in base plate 60 and heats pallet 70 placed on base plate 60.

First shaping unit 22 is a unit for shaping wiring of a circuit board, and includes first printing section 72 and sintering section 74. First printing section 72 includes inkjet head 76 (refer to Fig. 2), and inkjet head 76 linearly discharges metal ink. The metal ink is ink obtained by dispersing nanometer-sized metal fine particles, for example, silver fine particles in a solvent. A surface of the metal fine particles is coated with a dispersant and aggregation in the solvent is prevented. Further, inkjet head 76 discharges the metal ink from multiple nozzles by, for example, a piezo method using a piezoelectric element.

Sintering section 74 includes infrared irradiation device 78 (refer to Fig. 2). Infrared irradiation device 78 is a device for irradiating the discharged metal ink with infrared light, and the metal ink irradiated with infrared light is sintered to form the wiring. Sintering of the metal ink is, for example, a phenomenon in which evaporation of a solvent or decomposition of a protective film of metal fine particles, that is, a dispersant is performed by applying energy, so that conductivity is increased by contacting or fusing the metal fine particles. Then, the metal ink is sintered to form a metal wiring.

In addition, second shaping unit 24 is a unit for shaping a resin layer of a circuit board, and includes second printing section 84 and curing section 86. Second printing section 84 includes inkjet head 88 (refer to Fig. 2), and inkjet head 88 discharges an ultraviolet curable resin. The ultraviolet curable resin is a resin that is cured by irradiation with ultraviolet light. Inkjet head 88 may be, for example, a piezo type inkjet head using a piezoelectric element, or may be a thermal type inkjet head in which a resin is heated to generate air bubbles, which are discharged from multiple nozzles.

Curing section 86 includes flattening device 90 (refer to Fig. 2) and irradiation device 92 (refer to Fig. 2). Flattening device 90 flattens an upper surface of the ultraviolet curable resin discharged by inkjet head 88, and for example, scrapes up excess resin by a roller or a blade while smoothening the surface of the ultraviolet curable resin, to make the thickness of the ultraviolet curable resin uniform. In addition, irradiation device 92 includes a mercury lamp or LED as a light source, and irradiates the discharged ultraviolet curable resin with ultraviolet light. As a result, the discharged ultraviolet curable resin is cured to form a resin layer.

Imaging unit 26 is a unit for imaging pallet 70 placed on base plate 60 of stage 52, and includes camera 100. Camera 100 is disposed above base 29 in a posture facing downward, and images the upper surface of pallet 70 placed on base plate 60 of stage 52 from the above.

As illustrated in Fig. 2, control device 28 includes controller 110, multiple drive circuits 112, image processing device 114, and storage device 116. Multiple drive circuits 112 are connected to electromagnetic motors 38 and 56, holding device 62, lifting and lowering device 64, heater 66, inkjet head 76, infrared irradiation device 78, inkjet head 88, flattening device 90, and irradiation device 92. Controller 110 includes CPU, ROM, RAM, and the like, is mainly a computer, and is connected to multiple drive circuits 112. Thus, the operations of conveyance device 20, first shaping unit 22, second shaping unit 24, and imaging unit 26 are controlled by controller 110. Controller 110 is connected to image processing device 114. Image processing device 114 is for processing the imaging data obtained by camera 100, and controller 110 acquires various information from the imaging data. Storage device 116 stores various information determined based on the imaging data.

In circuit formation device 10, in the above-described configuration, a resin laminate is formed on pallet 70 placed on base plate 60 of stage 52, and wiring is formed on the upper surface of the resin laminate, whereby a circuit board is formed.

Specifically, as illustrated in Fig. 3, first, an operator adheres heat-sensitive release film 120 to the upper surface of pallet 70 placed on base plate 60 of stage 52. Since heat-sensitive release film 120 has adhesiveness, heat-sensitive release film 120 appropriately adheres to the upper surface of pallet 70. A circuit board is formed on heat-sensitive release film 120, and the adherence of heat-sensitive release film 120 to pallet 70 prevents a deviation of the circuit board during circuit formation. Since the adhesiveness of heat-sensitive release film 120 decreases by heating, heat-sensitive release film 120 together with the circuit board formed on heat-sensitive release film 120 can be easily released from pallet 70 by heating heat-sensitive release film 120 after the circuit board is formed on heat-sensitive release film 120.

When heat-sensitive release film 120 is adhered on pallet 70, stage 52 is moved below second shaping unit 24. **In** second shaping unit 24, as illustrated in Fig. 4, resin laminate 122 is formed on heat-sensitive release film 120. Resin laminate 122 is formed by repeating the discharge of the ultraviolet curable resin from inkjet head 88 and the irradiation with ultraviolet light by irradiation device 92 to the discharged ultraviolet curable resin.

Specifically, in second printing section 84 of second shaping unit 24, inkjet head 88 discharges the ultraviolet curable resin in a thin film shape on the upper surface of heat-sensitive release film 120. Subsequently, when the ultraviolet curable resin is discharged in the thin film shape, the ultraviolet curable resin is flattened by flattening device 90 in curing section 86 so that the ultraviolet curable resin has a uniform film thickness. Irradiation device 92 irradiates the thin film-shaped ultraviolet curable resin with ultraviolet light. As a result, thin film-shaped resin layer 124 is formed on heat-sensitive release film 120.

Subsequently, inkjet head 88 discharges the ultraviolet curable resin in a thin film shape onto thin film-shaped resin layer 124. The thin film-shaped ultraviolet curable resin is flattened by flattening device 90, irradiation device 92 irradiates the ultraviolet curable resin discharged in a thin film shape with ultraviolet light, and thus thin film-shaped resin layer 124 is laminated on thin film-shaped resin layer 124. As described above, the discharge of the ultraviolet curable resin on thin film-shaped resin layer 124 and the irradiation with the ultraviolet light are repeated, and multiple resin layers 124 are laminated and thus resin laminate 122 is formed.

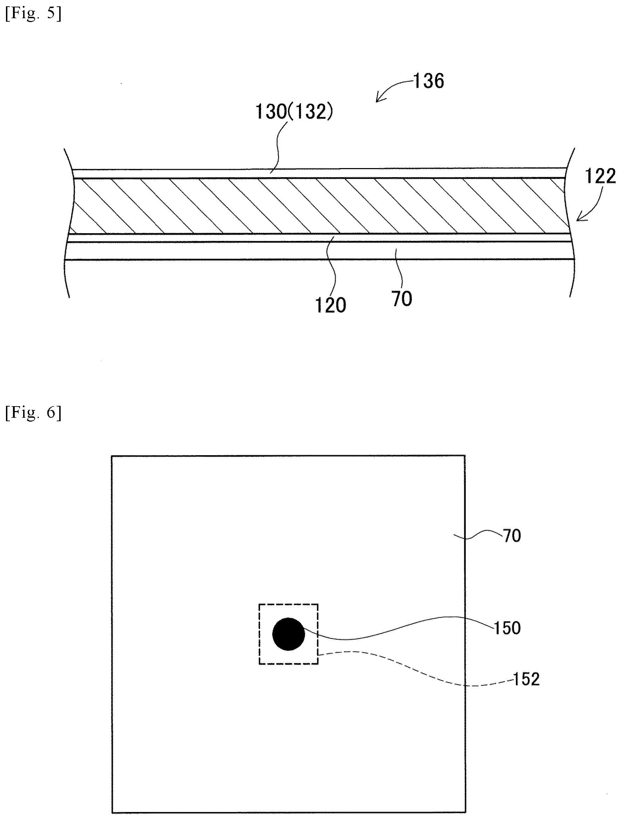

Next, when resin laminate 122 is formed, stage 52 is moved below first shaping unit 22. In first printing section 72 of first shaping unit 22, as illustrated in Fig. 5, inkjet head 76 linearly discharges metal ink 130 on the upper surface of resin laminate 122 in accordance with the circuit pattern. Subsequently, infrared irradiation device 78 irradiates metal ink 130 discharged in accordance with the circuit pattern with infrared light in sintering section 74 of first shaping unit 22. As a result, metal ink 130 is sintered, and wiring 132 is formed on the upper surface of resin laminate 122.

As described above, resin laminate 122 is formed on the upper surface of heat-sensitive release film 120, and wiring 132 is formed on the upper surface of resin laminate 122, whereby circuit board 136 is formed on heat-sensitive release film 120 on upper surface of pallet 70. In order to release heat-sensitive release film 120 from formed circuit board 136, heat-sensitive release film 120 is heated by heater 66 incorporated in base plate 60. As a result, the adhesiveness of heat-sensitive release film 120 decreases, so that circuit board 136 can be easily released from pallet 70 together with heat-sensitive release film 120. Then, heat-sensitive release film 120 is released from circuit board 136, whereby the formation of circuit board 136 is completed.

However, since heat-sensitive release film 120 is adhered to pallet 70 by the operator, circuit board 136 may be directly formed on pallet 70 without heat-sensitive release film 120 being adhered to pallet 70. In other words, resin laminate 122 may be formed by directly discharging the ultraviolet curable resin on pallet 70. In such a case, when circuit board 136 is released from pallet 70 after circuit board 136 is formed by bringing pallet 70 and resin laminate 122 into close contact with each other, resin laminate 122 of circuit board 136 may be damaged. Therefore, in circuit formation device 10, before circuit board 136 is formed on pallet 70, pallet 70 is imaged in imaging unit 26, and it is determined whether heat-sensitive release film 120 is adhered to pallet 70 based on the imaging data obtained through the imaging.

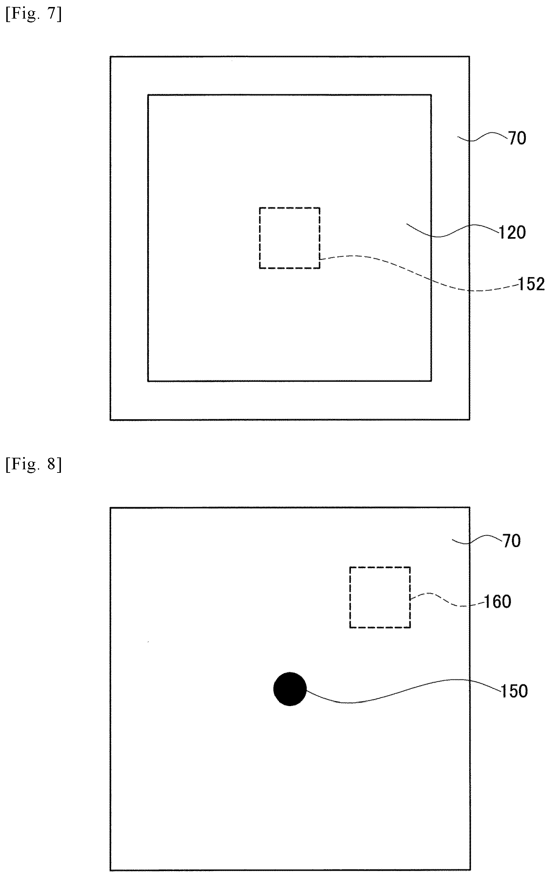

Specifically, as illustrated in Fig. 6, mark 150 is marked on the upper surface of pallet 70, and the position at which mark 150 is marked is an adhesion planned position where heat-sensitive release film 120 is to be adhered to pallet 70. When pallet 70 is set on base plate 60 of stage 52, stage 52 is moved below imaging unit 26 before resin laminate 122 is formed on pallet 70. Then, in imaging unit 26, camera 100 images pallet 70 set on base plate 60. Since the imaging range of camera 100 is narrow, predetermined range 152 (hereinafter, referred to as a "first range") (refer to Figs. 6 and 7) including the position of mark 150 on pallet 70 is set, and first range 152 is imaged by camera 100. The imaging data obtained through the imaging is then analyzed by controller 110, and based on the imaging data, it is determined whether heat-sensitive release film 120 is adhered to pallet 70. That is, based on the imaging data in first range 152, the presence or absence of mark 150 is determined. At this time, based on the imaging data in first range 152, in a case where it is determined that mark 150 is present as illustrated in Fig. 6, it is determined that heat-sensitive release film 120 is not adhered to pallet 70. On the other hand, based on the imaging data in first range 152, as illustrated in Fig. 7, in a case where it is determined that there is no mark 150, it is determined that heat-sensitive release film 120 is adhered to pallet 70. As a result, it is possible to determine whether heat-sensitive release film 120 is adhered to pallet 70.

However, in a case where heat-sensitive release film 120 is a film having a high transparency, even if heat-sensitive release film 120 is adhered to pallet 70, mark 150 may be visible through heat-sensitive release film 120. In other words, even if heat-sensitive release film 120 is adhered to pallet 70, it may be determined that there is mark 150 based on the imaging data. In such a case, it is erroneously determined that heat-sensitive release film 120 is not adhered to pallet 70 although heat-sensitive release film 120 is adhered to pallet 70. In view of such a case, it is determined not only whether heat-sensitive release film 120 is adhered to pallet 70 based on the presence or absence of mark 150, but also whether heat-sensitive release film 120 is adhered based on the brightness value of the imaging data.

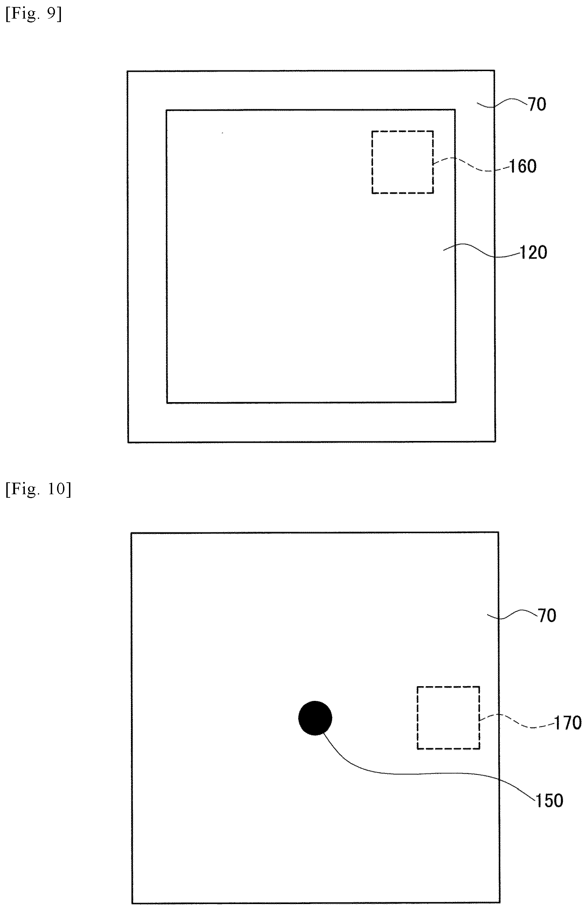

Specifically, predetermined range 160 (hereinafter, referred to as a "second range") (refer to Figs. 8 and 9) is set at a position different from the position of mark 150 of pallet 70 and at the adhesion planned position where heat-sensitive release film 120 is to be adhered to pallet 70. As illustrated in Fig. 8, in pallet 70 in a state in which heat-sensitive release film 120 is not adhered, second range 160 is imaged in advance by camera 100, and the brightness value is calculated in advance based on the imaging data. That is, the brightness value of second range 160 of pallet 70 (hereinafter, referred to as a "pallet brightness value") is calculated in advance. Further, as illustrated in Fig. 9, in pallet 70 in a state in which heat-sensitive release film 120 is adhered, second range 160 is imaged in advance by camera 100, and the brightness value is calculated in advance based on the imaging data. That is, the brightness value of second range 160 of heat-sensitive release film 120 adhered to pallet 70 (hereinafter, referred to as a "film brightness value") is calculated in advance. An intermediate value between the pallet brightness value and the film brightness value, such as an average value is calculated as a threshold value, and the threshold value, the pallet brightness value, and the film brightness value are set in advance in controller 110.

As described above, using a threshold value set in advance, it is determined whether heat-sensitive release film 120 is adhered to pallet 70. Specifically, as described above, after first range 152 is imaged by camera 100 in order to determine the presence or absence of mark 150, second range 160 is imaged by camera 100. Then, in controller 110, the imaging data obtained through the imaging is analyzed, and the brightness value of second range 160 (hereinafter, referred to as a "calculated brightness value") is calculated. Subsequently, in controller 110, it is determined the calculated brightness value is closer to any one of the pallet brightness value and the film brightness value with reference to the threshold value. At this time, in a case where it is determined that the calculated brightness value is close to the pallet brightness value, it is determined that heat-sensitive release film 120 is not adhered to pallet 70. On the other hand, in a case where it is determined that the calculated brightness value is close to the film brightness value, it is determined that heat-sensitive release film 120 is adhered to pallet 70. As a result, in addition to the method of determining whether heat-sensitive release film 120 is adhered using mark 150, whether heat-sensitive release film 120 is adhered is determined using the brightness value, so that the accuracy of determining whether heat-sensitive release film 120 is adhered can be increased.

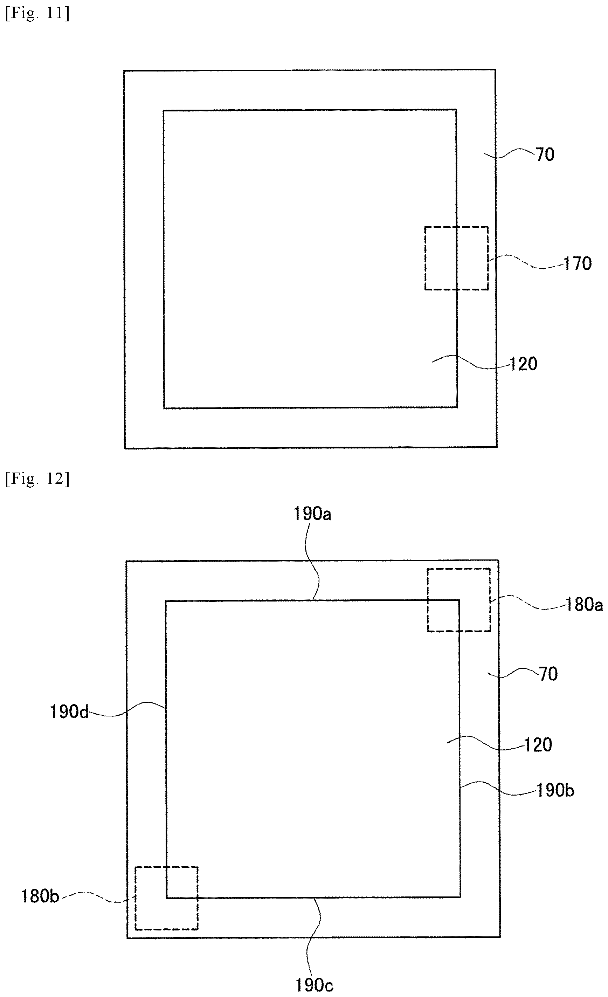

Further, in circuit formation device 10, whether heat-sensitive release film 120 is adhered is determined using not only the first determination method for determining whether heat-sensitive release film 120 is adhered using mark 150 and the second determination method for determining whether heat-sensitive release film 120 is adhered using the brightness value but also the third determination method. Specifically, predetermined range 170 (hereinafter, referred to as a "third range") (refer to Figs. 10 and 11) including a boundary between an adhesion planned position where heat-sensitive release film 120 is to be adhered on pallet 70 and a position where heat-sensitive release film 120 is not planned to be adhered is set. That is, third range 170 including the edge of the adhesion planned position of heat-sensitive release film 120 on pallet 70 is set. Therefore, as described above, after first range 152 and second range 160 are imaged by camera 100, third range 170 is imaged by camera 100. Then, the imaging data obtained through the imaging is analyzed by controller 110, and based on the imaging data, a boundary between the adhesion planned position of heat-sensitive release film 120 on pallet 70 and the position where heat-sensitive release film 120 is not planned to be adhered, that is, the presence or absence of a boundary line between heat-sensitive release film 120 and pallet 70 is determined. At this time, based on the imaging data in third range 170, as illustrated in Fig. 10, in a case where it is determined that there is no boundary line between heat-sensitive release film 120 and pallet 70, it is determined that heat-sensitive release film 120 is not adhered to pallet 70. On the other hand, based on the imaging data in third range 170, as illustrated in Fig. 11, when it is determined that there is a boundary line between heat-sensitive release film 120 and pallet 70, it is determined that heat-sensitive release film 120 is adhered to pallet 70. As a result, it is possible to determine whether heat-sensitive release film 120 is adhered to pallet 70.

As described above, in circuit formation device 10, whether heat-sensitive release film 120 is adhered is determined using the three determination methods which include the first determination method based on the presence or absence of mark 150, the second determination method based on the brightness value, and the third determination method based on the presence or absence of the boundary line between heat-sensitive release film 120 and pallet 70. As a result, it is possible to appropriately determine whether heat-sensitive release film 120 is adhered to pallet 70. As the three determination methods are performed, and in a case where it is determined that heat-sensitive release film 120 is adhered to pallet 70 by at least one determination method among the three determination methods, the shaping of the circuit board is performed. On the other hand, in all of the three determination methods, in a case where it is determined that heat-sensitive release film 120 is not adhered to pallet 70, the error notification is made without performing the shaping of the circuit board.

In addition, it is considered that the determination method by which whether heat-sensitive release film 120 is adhered can be determined is different according to the characteristics of heat-sensitive release film 120, specifically, for example, the transparency, the brightness value, the reflectance, and the like of heat-sensitive release film 120. That is, for example, in heat-sensitive release film A, it is determined that heat-sensitive release film 120 is adhered to pallet 70 by the first determination method and the third determination method, and in heat-sensitive release film B, it is determined that heat-sensitive release film 120 is adhered to pallet 70 by the second determination method. For this reason, in a case where it is determined that heat-sensitive release film 120 is adhered to pallet 70, the determination method for determining that heat-sensitive release film 120 is adhered to pallet 70 and the type of heat-sensitive release film are stored in storage device 116 in association with each other. That is, for example, heat-sensitive release film A and the first determination method and the third determination method are stored in storage device 116 in association with each other, and heat-sensitive release film B and the second determination method are stored in storage device 116 in association with each other. When it is determined again whether the same type of heat-sensitive release film is adhered to pallet 70, whether the heat-sensitive release film is adhered is determined using the determination method stored in storage device 116 in association with the type of heat-sensitive release film. In other words, in a case where it is determined whether heat-sensitive release film A is adhered to pallet 70 for a second time or later, whether heat-sensitive release film A is adhered is determined using the first determination method and the third determination method stored in storage device 116 in association with heat-sensitive release film A. As a result, it is possible to appropriately determine whether the heat-sensitive release film is adhered and to shorten the time required for the determination.

In addition, in a case where it is determined that the heat-sensitive release film is adhered to pallet 70 by the third determination method, that is, in a case where it is determined that there is a boundary line between heat-sensitive release film 120 and pallet 70 based on the imaging data, the adhesion position of heat-sensitive release film 120 is calculated based on the boundary line between heat-sensitive release film 120 and pallet 70. Specifically, two predetermined ranges 180a and 180b (hereinafter, referred to as a "fourth range") (refer to Fig. 12) including the two corners of the adhesion planned position of heat-sensitive release film 120 on pallet 70 are set. Two fourth ranges 180a and 180b are set at positions facing each other about the center of heat-sensitive release film 120 at the adhesion planned position of heat-sensitive release film 120. Then, after it is determined that there is a boundary line between heat-sensitive release film 120 and pallet 70 based on the imaging data, two fourth ranges 180a and 180b are imaged by camera 100. Then, in controller 110, the imaging data of two fourth ranges 180a and 180b is analyzed, and the positions of the two corners facing each other about the center of heat-sensitive release film 120 are calculated. A first one of the two corners is formed by two sides 190a and 190b of four sides 190 of heat-sensitive release film 120, and a second one of the two corners is formed by two sides 190c and 190d of four sides 190 of heat-sensitive release film 120. For this reason, the positions of four sides 190 of heat-sensitive release film 120 are calculated based on the positions of the two corners facing each other about the center of heat-sensitive release film 120, and the adhesion position of heat-sensitive release film 120 is further calculated based on the positions of four sides 190 of heat-sensitive release film 120. Then, circuit board 136 is formed on heat-sensitive release film 120 using the calculated adhesion position of heat-sensitive release film 120. That is, the discharging of the ultraviolet curable resin and the discharging of the metal ink are performed using the calculated adhesion position of heat-sensitive release film 120. In this manner, the adhesion position of heat-sensitive release film 120 based on the boundary line between heat-sensitive release film 120 and pallet 70 is calculated and circuit board 136 is formed using the adhesion position of heat-sensitive release film 120, whereby the forming accuracy of circuit board 136 can be increased.

In the above embodiment, circuit formation device 10 is an example of a shaping device. Control device 28 is an example of a determination device. Pallet 70 is an example of a pallet. Heat-sensitive release film 120 is an example of a film. Circuit board 136 is an example of a three-dimensional shaped object. Mark 150 is an example of a mark.

The present invention is not limited to the above embodiment, and can be performed in various aspects to which various modifications and improvements are applied within the scope of the appended claims. For example, in the above embodiment, it is determined whether the heat-sensitive release film is adhered to pallet 70 based on the pallet brightness value, the film brightness value, and the threshold value, but it may be determined whether the heat-sensitive release film is adhered to pallet 70 based on one of the pallet brightness value and the film brightness value. That is, for example, the brightness value of a predetermined range having the pallet brightness value as a center (hereinafter, referred to as a "pallet brightness value set range") is set. When the calculated brightness value is within the pallet brightness value set range, it is determined that the heat-sensitive release film is not adhered to pallet 70, and when the calculated brightness value is outside the pallet brightness value set range, it may be determined that the heat-sensitive release film is adhered to pallet 70. In addition, the present invention is not limited to the pallet brightness value and the film brightness value, and various color information can be adopted as long as it is information indicating the color of the pallet and the heat-sensitive release film (hereinafter, referred to as "color information"). For example, as the color information, information indicating various colors such as brightness, saturation, color tone, and the like can be adopted.

In addition, in the above embodiment, since camera 100 having a narrow imaging range is adopted, each of first range 152, second range 160, third range 170, and fourth range 180 is individually imaged. On the other hand, in a case where a camera having a larger imaging range than the heat-sensitive release film is adopted, all of first range 152, second range 160, third range 170, and fourth range 180 can be imaged at one time. As a result, it is possible to reduce the time required for imaging.

In addition, in the above embodiment, the ultraviolet curable resin is adopted as the resin for shaping the three-dimensional shaped object, but various curable resins such as a two-liquid mixed curable resin, a thermosetting resin, and a thermoplastic resin can be adopted. In addition, the material for shaping the three-dimensional shaped object is not limited to a resin, and various materials can be adopted as long as the material is a material for curing the fluid.

In addition, in the above embodiment, circuit board 136 is adopted as a three-dimensional shaped object, but various three-dimensional shaped objects such as a figure can be adopted.

### Reference Signs List

10: circuit formation device (shaping device), 28: control device (determination device), 70: pallet, 120: heat-sensitive release film (film), 136: circuit board (three-dimensional shaped object), 150: mark.

## Claims

1. A determination device used in a shaping device in which a three-dimensional shaped object is shaped on an upper surface of a film (120) adhered to a pallet (70), wherein
the determination device determines whether the film (120) is adhered to the pallet (70) based on imaging data of the pallet.

2. The determination device according to claim 1, wherein
the determination device determines whether the film is adhered to the pallet based on a presence or absence of a mark (150) marked at an adhesion planned position of the film on the pallet.

3. The determination device according to claim 1 or 2, wherein
the determination device determines whether the film is adhered to the pallet based on at least one of color information indicating color of the pallet or color information of the film adhered to the pallet.

4. The determination device according to any one of claims 1 to 3, wherein
the determination device determines whether the film is adhered to the pallet based on a presence or absence of a boundary between the pallet and the film.

5. The determination device according to claim 4, wherein
in a case where it is determined that the film is adhered to the pallet based on the presence or absence of the boundary between the pallet and the film, the determination device calculates an adhesion position of the film on the pallet based on a position of the boundary.

## Patentansprüche

1. Feststellungsvorrichtung, die in einer Formvorrichtung eingesetzt wird, in der ein dreidimensionales geformtes Objekt an einer oberen Fläche einer Folie (120) geformt wird, die an einer Palette (70) anhaftet, wobei
die Feststellungsvorrichtung auf Basis von Bilderzeugungsdaten der Palette feststellt, ob die Folie (120) an der Palette (70) anhaftet.

2. Feststellungsvorrichtung nach Anspruch 1, wobei
die Feststellungsvorrichtung auf Basis eines Vorhandenseins oder Nichtvorhandenseins einer Markierung (150), die an einer geplanten Anhaftposition der Folie an der Palette aufgebracht ist, feststellt, ob die Folie an der Palette anhaftet.

3. Feststellungsvorrichtung nach Anspruch 1 oder 2, wobei
die Feststellungsvorrichtung auf Basis von Farbinformationen, die Farbe der Palette angeben, oder Farbinformationen der an der Palette anhaftenden Folie feststellt, ob die Folie an der Palette anhaftet.

4. Feststellungsvorrichtung nach einem der Ansprüche 1 bis 3, wobei
die Feststellungsvorrichtung auf Basis eines Vorhandenseins oder Nichtvorhandenseins einer Grenze zwischen der Palette und der Folie feststellt, ob die Folie an der Palette anhaftet.

5. Feststellungsvorrichtung nach Anspruch 4, wobei
wenn auf Basis des Vorhandenseins oder Nichtvorhandenseins der Grenze zwischen der Palette und der Folie festgestellt wird, dass die Folie an der Palette haftet, die Feststellungsvorrichtung eine Anhaftposition der Folie an der Palette auf Basis einer Position der Grenze berechnet.

## Revendications

1. Dispositif de détermination utilisé dans un dispositif de mise en forme dans lequel un objet de forme tridimensionnelle est mise en forme sur une surface supérieure d'un film (120) collé à une palette (70), dans lequel
le dispositif de détermination détermine si le film (120) est collé ou non à la palette (70) sur la base des données d'imagerie de la palette.

2. Dispositif de détermination selon la revendication 1, dans lequel
le dispositif de détermination détermine si le film est collé ou non à la palette sur la base d'une présence ou absence d'une marque (150) marquée à une position d'adhérence prévue du film sur la palette.

3. Dispositif de détermination selon la revendication 1 ou 2, dans lequel
le dispositif de détermination détermine si le film est collé ou non à la palette sur la base d'au moins l'une d'informations de couleur indiquant une couleur de la palette ou d'informations de couleur du film collé à la palette.

4. Dispositif de détermination selon l'une quelconque des revendications 1 à 3, dans lequel
le dispositif de détermination détermine si le film est collé ou non à la palette sur la base de la présence ou absence d'une limite entre la palette et le film.

5. Dispositif de détermination selon la revendication 4, dans lequel
dans un cas où il est déterminé que le film est collé à la palette sur la base de la présence ou absence de la limite entre la palette et le film, le dispositif de détermination calcule une position d'adhérence du film sur la palette sur la base d'une position de la limite.
